# EUROPÄISCHE PATENTSCHRIFT

(11) **EP 0 432 367 B1**
(45) Veröffentlichungstag und Bekanntmachung des Hinweises auf die Patenterteilung: **01.12.1993**
(21) Anmeldenummer: 90116348.5
(22) Anmeldetag: 27.08.1990
(51) Int. Cl.: G01R 21/133, G11C 7/00

(54) **Tarifgerät mit sicherer bidirektionaler Schnittstelle**
Device for calculating the tariff with secure bidirectional interface
Dispositif pour calculer le tarif avec un circuit d'interface bidirectionnel fiable

(30) Priorität: 15.12.1989 CH 4514/89
(43) Veröffentlichungstag der Anmeldung: 19.06.1991
(73) Patentinhaber: Landis & Gyr Business Support AG, 6301 Zug (CH)
(72) Erfinder: Laumann, Horst, CH-6300 Zug (CH)
(74) Vertreter: Müller, Hans-Jürgen, Dipl.-Ing.

(56) Entgegenhaltungen:
- FR-A- 2 520 915
- GB-A- 2 183 852
- US-A- 4 580 039

## Beschreibung

Die Erfindung bezieht sich auf ein Tarifgerät der im Oberbegriff des Anspruchs 1 genannten Art; ein solches Tarifgerät ist in der US-A-45 80 039 beschrieben.

Ein Tarifgerät ist auch aus dem Protokoll 1987 der Fifth International Conference on Metering Apparatus and Tariffs for Electricity Supply (ISBN 0 85296346 7 ISSN 0537-9989), Seiten 86 bis 90 bekannt. Bei diesem Tarifgerät können im Datenspeicher abgelegte Daten über eine optische bidirektionale Schnittstelle in ein mobiles Ablesegerät übertragen werden und umgekehrt können Daten vom Ablesegerät in das Tarifgerät übertragen werden. Bei einer Ablesung werden beispielsweise die Uhrzeit und der Kalender auf den neuesten Stand gebracht; aber auch Parameter, die der Tarifgestaltung dienen, sind veränderbar.

Sofern Elektrizitätszähler und zugehörige Tarifgeräte der Eichpflicht unterliegen, werden diese Messgeräte nach der Eichung mittels Plomben verschlossen. Hiermit wird sichergestellt, dass eichrechtlich relevante Daten nur nach Verletzung der Plombierung verändert werden können. Beim oben erwähnten Tarifgerät sind aber Softwareparameter über die optische bidirektionale Schnittstelle veränderbar. Es bestehen Bedenken, solche Tarifgeräte zur Eichung zuzulassen, weil nicht auszuschliessen ist, dass bei nicht erkannten Fehlern in der Software auch der Verrechnung dienende Daten über die Schnittstelle verändert werden können.

Der Erfindung liegt die Aufgabe zugrunde, ein Tarifgerät mit einer bidirektionalen Schnittstelle zu schaffen, welches einfach überprüfbar und eichfähig ist.

Die Erfindung besteht in den im Kennzeichen des Anspruchs 1 angegebenen Merkmalen. Vorteilhafte Ausgestaltungen ergeben sich aus den Unteransprüchen.

Nachfolgend werden Ausführungsbeispiele der Erfindung anhand der Zeichnungen näher erläutert.

Es zeigen:
- Fig. 1: ein Teil eines Blockschemas eines Tarifgerätes,
- Fig. 2: ein Diagramm eines Signalverlaufes und
- Fig. 3: ein Teil eines zweiten Blockschemas eines Tarifgerätes.

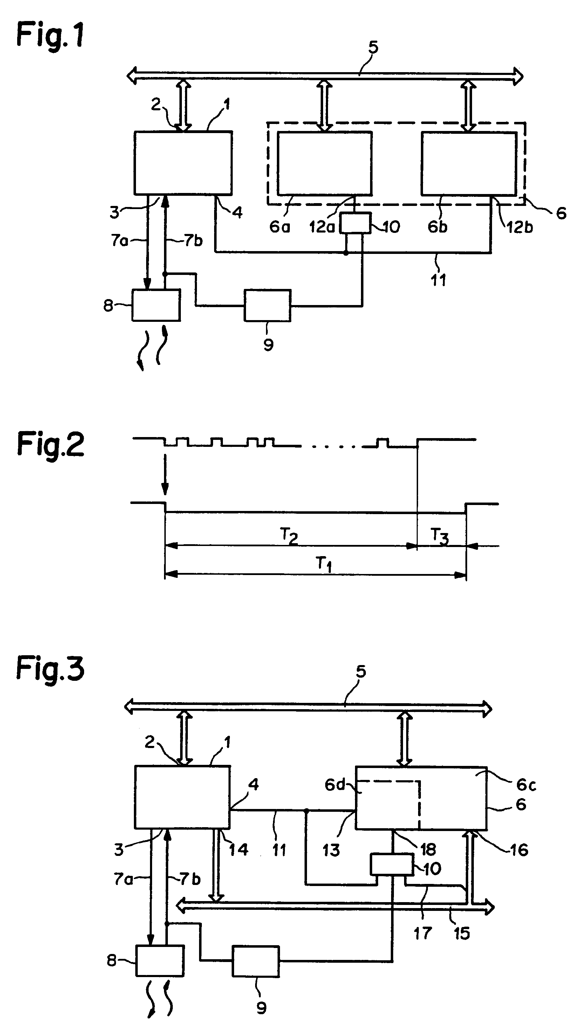

In der Fig. 1 ist ein Mikrocomputer 1 mit einem parallelen Datenport 2, einem seriellen Datenport 3 und einem Steuerausgang 4 für Signale "Speicher lesen" bzw. "Speicher beschreiben" dargestellt. Weitere für den Betrieb des Mikrocomputers 1 und des Tarifgerätes wichtige Einzelheiten sind der Einfachheit halber weggelassen. Der parallele Datenport 2 ist über einen Datenbus 5 mit einem Datenspeicher 6 verbunden. Der Datenspeicher 6 ist aus zwei Speicherblöcken 6a und 6b zusammengesetzt, die beide als Schreib/Lesespeicher ausgebildet sind. Im Speicherblock 6a sind Messwerte und Parameter, die zur Verrechnung der konsumierten Energie oder Leistung wichtig sind, abgespeichert. Im Speicherblock 6b sind Parameter von untergeordneter Bedeutung, wie z. B. die Uhrzeit, das Datum u.s.w abgespeichert. Ein Programmspeicher zur Speicherung des Betriebsprogrammes des Tarifgerätes ist im Mikrocomputer 1 integriert. Der serielle Datenport 3 ist über zwei Leitungen 7a und 7b mit einer bidirektionalen optischen Schnittstelle 8 verbunden. Diese Schnittstelle 8 dient zur Datenübertragung mit einem hier nicht gezeichneten Ablesegerät. Die Leitung 7a überträgt die Daten vom Mikrocomputer 1 zur optischen Schnittstelle 8 und die Leitung 7b überträgt die Daten in der umgekehrten Richtung. Die Leitung 7b ist zusätzlich mit einem Eingang eines Zeitgliedes 9 verbunden. Ein Ausgang des Zeitgliedes 9 ist an einen ersten Eingang einer logischen Schaltung 10 angeschlossen. Der Steuerausgang 4 des Mikrocomputers 1 ist über eine Steuerleitung 11 mit einem zweiten Eingang der logischen Schaltung 10 und mit einem Steuereingang 12b des Speicherblockes 6b verbunden. Der Ausgang der logischen Schaltung 10 ist mit einem Steuereingang 12a des Speicherblockes 6a verbunden.

Der Mikrocomputer 1 erhält inkrementale Impulse von einem hier nicht gezeichneten Elektrizitätszähler. Diese Impulse werden mit Parametern, die im Speicherblock 6a abgelegt sind, verknüpft und im Speicherblock 6a als Energie- und Leistungswerte aufsummiert. Die Energie- und Leistungswerte können auf einer nicht gezeichneten Anzeigeeinheit angezeigt werden. Für Verrechnungszwecke werden diese Daten über die optische Schnittstelle 8 in das Ablesegerät übertragen und von diesem an eine Datenverarbeitungsanlage zur Rechnungsstellung weitergegeben.

Eine Datenübertragung über die optische Schnittstelle 8 wird mit einem Aufforderungstelegramm vom Ablesegerät zum Mikrocomputer 1 eröffnet. Das Aufforderungstelegramm veranlasst den Mikrocomputer 1 Daten, die im Datenspeicher 6 abgelegt sind, über den Datenbus 5 und den parallelen Datenport 2 zu holen, in einen seriellen Datenstrom umzuwandeln und über den seriellen Datenport 3 und die Leitung 7a an die optische Schnittstelle 8 zu leiten. Umgekehrt können Daten vom Ablesegerät an die optische Schnittstelle 8 und von da über die Leitung 7b an den seriellen Datenport 3 des Mikrocomputers 1 übertragen werden. Der Mikrocomputer 1 wandelt die seriellen Daten in parallele Daten um und gibt sie über den parallelen Datenport 2 an den Datenspeicher 6 weiter. Daten können aus dem Datenspeicher 6 ausgelesen beziehungsweise eingeschrieben werden, wenn am Datenspeicher 6 die entsprechende Adresse anliegt und der Steuereingang 12a bzw. 12b das Signal "Speicher lesen" oder "Speicher beschreiben", beispielsweise logisch "1" für "lesen" und logisch "0" für "beschreiben" führt.

Die Leitung 7b ist im normalen Betriebszustand des Tarifgerätes, d. h. wenn keine Ablesung stattfindet, in einem stabilen Zustand von beispielsweise logisch "1". Bei Beginn des Aufforderungstelegrammes ändert die Leitung 7b ihren Zustand von "1" zu "0". Durch den Zustandswechsel der Leitung 7b wird das Zeitglied 9 angestossen und für die Dauer einer Datenübertragung aktiviert. Sein Ausgang kippt von einem Zustand von beispielsweise "1" in einen Zustand "0". Die logische Schaltung 10 verknüpft das Zeitglied 9 und die Steuerleitung 11 derart, dass während der Datenübertragung der Speicherblock 6a gegen das Beschreiben gesperrt ist. Der Speicherblock 6a kann also während einer Datenübertragung mit dem Ablesegerät nur gelesen werden, währenddem der Speicherblock 6b sowohl gelesen als auch beschrieben werden kann.

Während einer Ablesung vom Elektrizitätszähler her eintreffende Impulse müssen zwischengespeichert werden. Sie können erst nach Beendigung der Ablesung in den Speicherblock 6a eingeschrieben werden. Die Impulse können beispielsweise in einem im Mikrocomputer 1 integrierten Schreib/Lesespeicher zwischengespeichert werden.

Während einer Datenübertragung mit dem Ablesegerät ist also ein vorbestimmter Speicherbereich, nämlich der Speicherblock 6a, des Datenspeichers 6 gegen das Einschreiben von Daten gesperrt. Die im Speicherblock 6a abgelegten Daten sind somit zuverlässig vor Veränderung geschützt.

Die aus dem Zeitglied 9, der logischen Schaltung 10 und der Steuerleitung 11 bestehenden Sperrschaltung, die während der Datenübertragung den Speicherblock 6a gegen das Einschreiben von Daten sperrt, ist vorteilhaft derart ausgebildet, d. h. übersichtlich und zugänglich angeordnet, dass ihre Funktion bei der Eichung des Tarifgerätes auf einfache Art und Weise überprüfbar ist. Dies im Unterschied zu einer Software, bei der eine Funktionsprüfung sehr aufwendig ist.

Im oberen Diagrammteil der Fig. 2 ist das Eingangssignal und im unteren das Ausgangssignal des Zeitgliedes 9 dargestellt. Das Eingangssignal ändert dann und nur dann seinen Zustand, wenn eine Ablesung stattfindet. Mit dem ersten Flankenwechsel wird das Zeitglied 9 angestossen und damit ändert das Ausgangssignal für die Zeit T₁ den Zustand. Die Zeit T₁ setzt sich zusammen aus der Datenübertragungszeit T₂ und einer Sicherheitszeit T₃. Nach der Zeit T₁ nimmt der Ausgang des Zeitgliedes 6 wieder den ursprünglichen Zustand an.

Falls die Datenübertragungszeit T₂ nicht konstant ist, kann das Zeitglied 6 so ausgebildet sein, dass mit jedem Flankenwechsel des Eingangssignales die Sicherheitszeit T₃ neu gestartet wird.

Die Fig. 3 zeigt eine Variante der Schaltung nach der Fig. 1, wobei gleiche Bezugszahlen wie in der Fig. 1 auf gleiche oder gleichwirkende Teile hinweisen. Der Datenspeicher 6 ist als einziger Speicherblock ausgebildet und in zwei Speicherbereiche 6c und 6d unterteilt. Im Speicherbereich 6d sind diejenigen Messwerte und Parameter abgespeichert, die für die Verrechnung wichtig sind. Im Speicherbereich 6c sind Parameter von untergeordneter Bedeutung abgespeichert. Der Ausgang des Zeitgliedes 9 ist mit einem ersten Eingang der logischen Schaltung 10 verbunden. Der Steuerausgang 4 des Mikro-Computers 1 ist über die Steuerleitung 11 an einen Steuereingang 13 des Datenspeichers 6 und an einen zweiten Eingang der logischen Schaltung 10 angeschlossen. Ein Adressport 14 des Mikrocomputers 1 ist über einen Adressbus 15 mit einem Adressport 16 des Datenspeichers 6 verbunden, wobei diejenige Adressleitung 17, die den Speicherbereich 6d definiert, mit einem dritten Eingang der logischen Schaltung 10 verbunden ist. Der Ausgang der logischen Schaltung 10 ist mit demjenigen Adresseingang 18 verbunden, die den Speicherbereich 6d definiert.

Die Funktion des Tarifgerätes nach der Fig. 3 unterscheidet sich von der Funktion des Tarifgerätes nach der Fig. 1 insofern, als nicht ein ganzer Speicherblock 6a, sondern nur ein Speicherbereich 6d während einer Datenübertragung gegen Beschreiben gesperrt ist, aber ein Lesen zulässt. Die logische Schaltung 10 decodiert zu diesem Zweck das Signal der Steuerleitung 11, den Ausgang des Zeitgliedes 9 und der Adressleitung 17. Der Speicherbereich 6d kann dadurch vergrössert werden, dass weitere logische Schaltungen 10 angeordnet sind, die weitere Adressleitungen mit der Steuerleitung 11 und dem Ausgang des Zeitgliedes 9 verknüpfen.

Die Schaltung nach der Fig. 3 ermöglicht eine kostengünstige Lösung in denjenigen Fällen, wo die Menge der gespeicherten Daten in einem Datenspeicher 6, der aus einem einzigen Baustein besteht, Platz hat.

Bei dem beschriebenen Tarifgerät ist auf einfache Art und Weise überprüfbar, welche Daten mit einem Ablesegerät verändert werden können und welche nicht. Zu diesem Zwecke ist nur die Hardware zu überprüfen, was mit relativ geringem Aufwand möglich ist. Solche Tarifgeräte sind somit eichfähig.

## Patentansprüche

1. Tarifgerät mit einem Mikrocomputer (1), einem Datenspeicher (6), einer Schnittstelle (8) und einer Sperrschaltung (9, 10, 11), die einen vorbestimmten Speicherbereich (6a; 6d) des Datenspeichers (6) gegen das Einschreiben von Daten sperrt und bei der die Sperrung zum Eingeben von Daten in den Datenspeicher (6) wieder aufhebbar ist,
**dadurch gekennzeichnet,**
daß die Schnittstelle (8) zur bidirektionalen Datenübertragung von und zu einem externen Terminal dient und daß die Sperrschaltung (9, 10, 11) ein Zeitglied (9) aufweist, welches durch ein die Ablesung von Daten aus dem Datenspeicher (6) über die Schnittstelle (8) veranlassendes Aufforderungstelegramm so aktivierbar ist, daß während einer für das Auslesen erforderlichen Datenübertragungszeit (T2) und einer Sicherheitszeit (T3) das Einschreiben von Daten in den vorbestimmten Speicherbereich (6a; 6d) gesperrt ist.

2. Tarifgerät nach Anspruch 1,
**dadurch gekennzeichnet,**
daß das Zeitglied (9) und eine Steuerleitung (11), die den Datenspeicher (6) zum Einschreiben von Daten freigibt, derart mit einer logischen Schaltung (10) verknüpft sind, daß der vorbestimmte Speicherbereich (6a) während des Auslesens von Daten gegen das Einschreiben von Daten gesperrt ist.

3. Tarifgerät nach Anspruch 2,
**dadurch gekennzeichnet,**
daß eine dem vorbestimmten Speicherbereich (6d) entsprechende Anzahl von Adreßleitungen (17) mit der logischen Schaltung (10) und einem Adressbus (15) zwischen dem Mikrocomputer (1) und dem Datenspeicher (6) verknüpft ist.

4. Tarifgerät nach einem der vorhergehenden Ansprüche,
**dadurch gekennzeichnet,**
daß ein im Mikrocomputer (1) enthaltener Schreib-/Lesespeicher die von einem Energiezähler eintreffenden Daten während des Ablesens zwischenspeichert.

## Claims

1. A tariff arrangement comprising a microcomputer (1), a data memory (6), an interface (8) and an inhibiting circuit (9, 10, 11) which inhibits a predetermined memory region (6a; 6d) of the data memory (6) to prevent the writing in of data and in which the inhibition can be removed again for the input of data into the data memory (6), characterised in that the interface (8) serves for bidirectional transfer of data from and to an external terminal and that the inhibiting circuit (9, 10, 11) has a timing member (9) which can be so activated by a request telegram that causes data to be read out of the data memory (6) by way of the interface (8) that during a data transfer time (72) which is required for the reading-out operation and a safety time (T3) the writing in of data into the predetermined memory region (6a; 6d) is inhibited.

2. A tariff arrangement according to claim 1 characterised in that the timing member (9) and a control line (11) which enables the data memory (6) for data to be written into same are linked to a logic circuit (10) in such a way that during the operation of reading out data the predetermined memory region (6a) is inhibited to prevent data from being written into same.

3. A tariff arrangement according to claim 2 characterised in that a number of address lines (17) which corresponds to the predetermined memory region (6d) is linked to the logic circuit (10) and an address bus (15) between the microcomputer (1) and the data memory (6).

4. A tariff arrangement according to one of the preceding claims characterised in that a randan access memory which is contained in the microcomputer (1) provides for intermediate storage of the data received from an electricity meter during the reading-out operation.

## Revendications

1. Appareil tarifaire comprenant un micro-ordinateur (1), une mémoire de données (6), une interface (8) et un circuit de blocage, (9, 10, 11) qui empêche l'écriture de données dans une zone de mémoire prédéfinie (6a; 6d) de la mémoire (6) de données, et dans lequel le blocage à l'entrée de données dans la mémoire (6) de données peut être supprimé,
**caractérisé en ce que** l'interface (8) sert à un transfert bidirectionnel de données depuis un terminal externe et vers celui-ci et en ce que le circuit de blocage (9, 10, 11) comprend un relais temporisateur (9) qui peut être actionné par un message d'invitation à transmettre, qui provoque une lecture de données dans la mémoire (6) de données par l'intermédiaire de l'interface (8), d'une manière telle que l'écriture de données dans la zone prédéterminée de données (6a; 6d) est bloquée pendant un temps de transfert de données nécessaire pour la lecture (T2) et pendant un temps de sécurité (T3).

2. Appareil tarifaire selon la revendication 1,
**caractérisé en ce que,**
le relais temporisateur (9) et une ligne de commande (11), qui libère la mémoire (6) de données pour l'écriture de données, sont reliés à un circuit logique (10) d'une manière telle que la zone prédéterminée de mémoire (6a) est bloquée vis-à-vis de l'écriture de données pendant la lecture de données.

3. Appareil tarifaire selon la revendication 2,
**caractérisé en ce que**
un nombre de lignes d'adresses (17), correspondant à la zone prédéterminée (6d) de mémoire, est relié au circuit logique (10), et à un bus d'adresses (15) entre le micro-ordinateur (1) et la mémoire (6) de données.

4. Appareil tarifaire selon la revendication précédente,
**caractérisé en ce que**
une mémoire d'écriture/de lecture contenue dans le micro-ordinateur (1) entre en tampon, pendant la lecture, les données entrantes venant du compteur d'énergie.
